# EUROPÄISCHE PATENTSCHRIFT

(11) **EP 2 430 756 B1**
(45) Veröffentlichungstag und Bekanntmachung des Hinweises auf die Patenterteilung: **12.12.2018**
(21) Anmeldenummer: 11730175.4
(22) Anmeldetag: 03.03.2011
(51) Int. Cl.: H03K 17/95

(54) **SENSOR**
SENSOR
CAPTEUR

(30) Priorität: 20.05.2010 DE 102010021118; 15.04.2010 DE 102010015252
(43) Veröffentlichungstag der Anmeldung: 21.03.2012
(73) Patentinhaber: Micro-Epsilon Messtechnik GmbH & Co. KG, 94496 Ortenburg (DE)
(72) Erfinder: HOENICKA, Reinhold, 94496 Ortenburg (DE); MEILHAMER, Alfons, 94094 Rotthalmünster (DE)
(74) Vertreter: Patent- und Rechtsanwälte Ullrich & Naumann
(86) Internationale Anmeldenummer: PCT/DE2011/000224
(87) Internationale Veröffentlichungsnummer: WO 2011/127882

(56) Entgegenhaltungen:
- EP-A1- 0 383 974
- DE-A1- 10 341 113
- DE-C1- 3 730 113
- DE-U- 7 438 475
- US-A- 3 473 110
- US-A- 3 942 045
- US-A- 5 801 530
- US-A- 5 814 986

## Beschreibung

Die Erfindung betrifft einen Sensor mit einem eine Messseite und eine Anschlussseite definierenden Gehäuse, wobei in dem Gehäuse messseitig eine Spule angeordnet ist. Folglich handelt es sich hier um einen induktiv arbeitenden kontaktlosen Wegmess-/Abstandssensor, wie er beispielsweise aus der US 3,473,110 seit langem bekannt ist.

Sensoren der gattungsbildenden Art werden heutzutage mit ganz besonderen Anforderungsprofilen auf unterschiedlichsten Gebieten eingesetzt, beispielsweise in der Luftfahrt, der Eisenbahn, im Offshore-Bereich, etc. Insbesondere bei der Luftfahrt werden hermetisch abgedichtete induktive Sensoren verwendet. Diese bestehen üblicherweise aus einem nicht oder nur sehr schwach magnetischen Gehäuse, beispielsweise aus Edelstahl oder Titan. Im Gehäuse befindet sich üblicherweise ein Kern mit ferromagnetischen Eigenschaften, beispielsweise aus der Legierung "Permalloy" oder aus einem sinter-ferritischen Material. Gemeinsam mit dem Kern ist der Spulenkörper in das Gehäuse eingebracht. Messseitig ist das Sensorgehäuse üblicherweise mit geringer Materialstärke geschlossen. Auf der Anschlussseite kann die Abdichtung über Metall-Glas-Durchführungen erfolgen, wobei regelmäßig eine abschließende Kupplung bzw. Buchse oder ein Stecker vorgesehen ist.

Bei dem aus der US 3,473,110 bekannten Sensor ist die Sensorspule eingebettet in einen Schalenkern bzw. Topfkern. Dieser besitzt einen zentralen Zapfen, einen Boden und eine dünnwandige Außenwand, wodurch eine rotationssymmetrische Öffnung in Form einer kreisringförmigen Nut im Kern entsteht, in die die Spule eingebracht ist. Der Schalenkern besteht aus gesintertem Ferrit oder aus weichmagnetischem Stahl, beispielsweise aus Permalloy. Das Gehäuse besteht aus einem nicht-ferromagnetischen Material, in das die Spule und der Kern eingebaut sind. Im Bereich der Luftfahrt oder in industrieller Schadatmosphäre werden üblicherweise Gehäuse aus Edelstahl verwendet. Das Gehäuse verfügt messseitig entweder über eine das Gehäuse abschließende Kappe, die mit dem Gehäuse verschweißt oder verlötet ist. Es kann auch messseitig geschlossen sein, wobei anschlussseitig eine Bohrung zur Aufnahme von Spule und Kern eingearbeitet ist.

Zum elektrischen Anschluss ist entweder ein integriertes Kabel oder ein Stecker bzw. eine Kupplung/Buchse vorgesehen.

Der aus der US 3,473,110 bekannte Sensor ist in vielerlei Hinsicht problematisch. So ist es äußerst schwierig, eine dauerhafte Abdichtung zwischen dem Kabel und dem Gehäuse zu realisieren. Die zur hermetischen Abdichtung erforderliche Haftung eines Vergussmaterials gegenüber dem Gehäuse ist kaum zu bewerkstelligen. Übliche Einsatzbedingungen wie beispielsweise hohe Temperaturen, Temperaturschwankungen, aggressive Medien, Unter- bzw. Überdruck, alternierende Drücke, etc. sind die Ursache. Insbesondere bei einer hohen Anzahl von Druck- oder Temperaturwechseln, wie sie beispielsweise in Flugzeugen auftreten, sind Undichtigkeiten bzw. Leckagen zu befürchten.

Die Patentschriften DE3730113 C1, US3942045 A, US5814986 A, EP0383974 A1, DE7438475U, US5801530 A offenbaren weitere Sensoren gemäß dem Stand der Technik.

Es sind auch Sensoren mit integrierten Steckern anstelle von integrierten Steckern/ Buchsen anstelle von integrierten Kabeln bekannt. Die Realisierung dichter Stecker ist jedoch äußerst aufwändig und teuer in der Herstellung. Sofern das Sensorgehäuse messseitig geschlossen ist, hat man das Problem einer hinreichend guten Abdichtung zur Anschlussseite hin verlagert. Dichte Steckverbindungen haben den Nachteil, dass sie teuer sind. Ein integrierter Stecker bzw. eine entsprechende Kupplung/Buchse erfordert außerdem einen nicht unerheblichen Raum, wodurch sich eine beachtliche Baugröße des Sensors ergibt. Dies gilt umso mehr, als der Gegenstecker den erforderlichen Einbauraum des Sensors abermals verlängert. Gegenüber dem einfachen Anschluss mittels eines integrierten Kabels kann sich dadurch der erforderliche Bauraum annähernd verdreifachen.

Des Weiteren ist es äußerst aufwändig, bei dem bekannten Sensor das Sensorgehäuse von der Anschlussseite her zu bohren bzw. zu fräsen, zumal die Wandstärke auf der Messseite möglichst dünn sein soll, um nämlich die elektromagnetischen Felder nicht all zu sehr zu beeinträchtigen.

Schließlich ergeben sich erhebliche Kosten aufgrund des erforderlichen Kerns, nämlich zum einen die Herstellkosten des Kerns und zum anderen Kosten bedinat durch den Zusammenbau mit dem Kerns. Kerne aus Permalloy oder ähnlichen weichmagnetischen Metallen werden zerspanend gefertigt, was aufwändig und teuer ist. Weiterhin muss dieser innerhalb des Gehäuses aufwändig positioniert und beispielsweise durch ein Federelement von der Anschlussseite her gegen die Messseite des Gehäuses gedrückt werden, um nämlich den Kern und somit die Spule definiert und temperaturstabil in eine feste Position gegenüber der Stirnseite bzw. Messseite des Gehäuses zu verbringen.

Im Lichte der voranstehend geschilderten Probleme liegt der vorliegenden Erfindung die Aufgabe zugrunde, diese insbesondere in Bezug auf die den Kern betreffenden Nachteile weitestgehend zu eliminieren.

Die voranstehende Aufgabe ist durch einen Sensor mit den Merkmalen des Patentanspruchs 1 gelöst. Dieser Sensor umfasst ein eine Messseite und eine Anschlussseite definierendes Gehäuse, wobei in dem Gehäuse - messseitig - eine Spule angeordnet ist. Das Sensorgehäuse ist geschlossen, nämlich messseitig, vorzugsweise mittels einer Abdeckung. An dieser Stelle sei angemerkt, dass hier der Begriff "Abdeckung" im weitesten Sinne zu verstehen ist. Dabei kann es sich auch um ein messseitig (stirnseitig) geschlossenes Gehäuse mit dünn ausgeführter Stirnseite handeln. Jedenfalls dient die Abdeckung zum messseitigen Verschließen des Gehäuses, ganz gleich, ob diese integraler Bestandteil des Gehäuses ist oder ob es sich dabei um ein zusätzliches Bauteil handelt.

In Bezug auf die Erfindung ist es von ganz besonderer Bedeutung, dass das Gehäuse aus einem ferromagnetischen Material besteht, insbesondere aus einem ferromagnetischen Stahl. Bei dem Stahl kann es sich insbesondere um einen ferromagnetischen Edelstahl unterschiedlichster Ausprägung handeln. Die Spule ist nahe der Abdeckung oder unmittelbar an der Abdeckung im Gehäuse positioniert und entsprechend fixiert.

Erfindungsgemäß ist erkannt worden, dass der im Stand der Technik betriebene Aufwand unter Verwendung eines separaten Kerns nicht erforderlich ist, nämlich dann, wenn das Gehäuse aus einem ferromagnetischen Material besteht, vorzugsweise mit mittlerer oder hoher relativer Permeabilität. Handelsübliche ferromagnetische Stähle besitzen beispielsweise eine relative Permeabilität im Bereich µr ≈ 1200..1500. Dabei wirkt das Gehäuse wie ein Kern und dient zur Feldführung und Erhöhung der Induktivität. Bei der Abdeckung handelt es sich um ein nichtferromagnetisches Material, wodurch das Gehäuse messseitig verschlossen ist.

Jedenfalls ist es in erfindungsgemäße Weise nicht erforderlich, eine hinreichend gute induktive Wirkung unter Verwendung eines dieskreten Kerns zu realisieren. Stattdessen wirkt das Gehäuse in besonders raffinierter Weise im Sinne eines herkömmlichen Kerns, nämlich aufgrund der besonderen spezifischen Materialeigenschaften des Gehäuses und dessen Ausgestaltung in Form eines Topfkernes. In erfindungsgemäßer Weise wird somit die Kontur von bekannten Topfkernen im Gehäuse nachgebildet. Der zentrale Zapfen wirkt dabei analog zu den bekannten Topfkernen zur Feldverstärkung und Feldführung der durch die Spule erzeugten elektromagnetischen Felder. Dadurch entfällt der diskrete Kern, was enorme Einsparungen aufgrund des Wegfalls des Kerns und des einfachen Zusammenbaus ermöglicht.

In vorteilhafter Weise hat das Material des Gehäuses eine mittlere bis hohe relative Permeabilität, nämlich zur Feldführung und Erhöhung der Induktivität.

Die Spule ist in weiter vorteilhafter Weise als Luftspule ausgeführt, die in die durch geeignete Bearbeitung des ferromagnetischen Gehäuses entstehende Öffnung in das Gehäuse eingebaut sein kann. Erfindungsgemäß ist im Inneren des Gehäuses, in koaxialer Anordnung, ein integraler Zapfen im Sinne eines Spulenkerns zur Aufnahme und Positionierung der Spule ausgebildet. Das Innere des Gehäuses hat somit eine topfartige Gestalt, wie sie aus der Anwendung von Schalen- oder Topfkernen bekannt ist. Da der Kern entfällt, ergeben sich - per se - Kostenvorteile gegenüber der herkömmlichen Bauform. Außerdem vereinfacht sich die Montage des Sensors ganz erheblich, wodurch ein weiterer Kostenvorteil entsteht.

Der im Innern des Gehäuses ausgebildete Zapfen hat die Form eines mittigen Zylinders. Die Spule wird bei der Fertigung auf diesen Zylinder aufgesteckt bzw. aufgeschoben, wobei weitere Mittel von Vorteil sind, die die Spule nahe der Messseite halten bzw. positionieren. Diesbezügliche Maßnahmen werden später noch erläutert werden.

In weiter vorteilhafter Weise ist das Gehäuse im Inneren unterteilt, nämlich durch einen Bodenbereich in einen messseitigen Spulenbereich und in einen anschlussseitigen Anschlussbereich. Sofern diese beiden Bereiche hermetisch voneinander getrennt bzw. abgedichtet sind, ist es nur noch erforderlich, das Gehäuse messseitig mittels der Abdichtung hermetisch abzudichten. Weitere Dichtmaßnahmen sind nicht erforderlich, zumal der Anschlussbereich auch ohne eine weiterreichende Abdichtung den Anforderungen genügt.

In Bezug auf den Anschluss der Spule ist es von Vorteil, wenn dieser mindestens zwei vorzugsweise starre Anschlusskontakte aufweist, die vorzugsweise in Form angelöteter Kontaktstifte oder Kontaktröhrchen ausgebildet sind. Die Kontaktstifte bzw. Kontaktröhrchen erstrecken sich durch Durchgänge im Bodenbereich hindurch, und zwar vom Sensorbereich durch den Bodenbereich hindurch in den Anschlussbereich hinein. Die Anschlusskontakte sind gegenüber dem Gehäuse elektrisch isoliert.

Zur elektrischen Isolierung der Kontaktstifte/Kontaktröhrchen ist es denkbar, dass Isolier-Durchführungen vorgesehen sind, beispielsweise aus Keramik oder Glas. Diese Isolier-Durchführungen werden in die Durchgänge eingesteckt bzw. eingepresst, eingeklebt oder eingelötet. Beliebige abdichtende Maßnahmen sind denkbar. Wesentlich ist jedenfalls, dass durch die Isolier-Durchführungen hindurch die Kontaktstifte/Kontaktröhrchen hindurchgeführt sind, so dass ein elektrischer Kontakt zwischen den Kontaktstiften/Kontaktröhrchen und dem Gehäuse wirksam vermieden ist.

Ebenso ist es denkbar, dass zur Isolation eine die Durchgänge und somit den Spulenbereich gegenüber dem Anschlussbereich abdichtende Verglasung vorgesehen ist. Eine solche Verglasung kann in Unterdruckatmosphäre erzeugt werden, wobei bei durchgesteckten Kontaktstiften/Kontaktröhrchen die durch den Bodenbereich hindurchragenden Durchgänge mit Glas vergossen werden. Dabei ist darauf zu achten, dass eine gute Haftung zwischen dem Glas und der Metalloberfläche einerseits und der Oberfläche der Kontaktstifte/Kontaktröhrchen andererseits realisiert wird, nämlich unter Berücksichtigung einer möglichst geringen, sich einstellenden Grenzflächenenergie. Eine solche Verglasung, beispielsweise in konkreter Ausführung eine sogenannte Vakuumverglasung, schafft eine hinreichend gute Abdichtung zwischen den beiden Bereichen - Spulenbereich und Anschlussbereich - wobei zu berücksichtigen ist, dass im Falle der Verwendung von Kontaktröhrchen ein innerer Durchgang besteht. Dieser lässt sich ganz einfach dadurch schließen, dass man anschlussseitig, d.h. vom Anschlussbereich her, weiterführende Anschlusskabel, beispielsweise in Form einer Litze, löttechnisch mit den Kontaktröhrchen verbindet, wobei aufgrund der Kapillarwirkung das flüssige Lötzinn in die Röhrchen eindringt und dort ebenfalls für eine hermetische Abdichtung zwischen den beiden Bereichen sorgt. Eine crimptechnische Verbindung des weiterführenden Anschlusskabels mit den Kontaktstiften ist ebenfalls realisierbar.

Der messseitigen Abdeckung des Gehäuses kommt im Rahmen einer hermetischen Kapselung des Sensorelements eine ganz besondere Bedeutung zu. Diese Abdeckung besteht aus einem nicht-ferromagnetischen Material, beispielsweise aus einer Metall- oder Keramikscheibe, die in einen ausgefrästen Bereich des Gehäuses stirnseitig einsetzbar ist. Ebenso ist es denkbar, dass die Abdeckung im Sinne einer Kappe ausgebildet ist, die das Sensorgehäuse messseitig zumindest geringfügig um- bzw. übergreift.

In Bezug auf eine hermetische Abdichtung ist es von ganz besonderem Vorteil, wenn die Abdeckung stoffschlüssig in das messseitige Ende des Gehäuses eingepasst wird, wobei diese mit dem Gehäuse verklebt, verschweißt, verlötet oder dort sonst wie befestigt sein kann. Eine Presspassung mit eingebundener Dichtung ist ebenfalls denkbar.

Zur weiterreichenden elektrischen Isolation kann es von Vorteil sein, wenn zwischen der Abdeckung und der Spule ein elektrischer Isolierkörper vorgesehen ist, wobei es sich dabei um einen Isolierkörper in Form einer sehr dünnen Isolierscheibe oder in Form einer Isolierfolie handeln kann. Entsprechende Isoliermittel in Form von Scheiben, Folien oder anderen nichtleitenden Materialien können auch zum Boden hin oder seitlich zur Außenwand des Sensors eingebracht werden, um die Spule zu isolieren. Auch ein günstig herzustellender Spulenkörper aus solchen Materialien ist denkbar.

Wie bereits zuvor erwähnt, ist es von Vorteil, wenn zwischen der Spule und dem Gehäuseboden ein Druckmittel vorgesehen ist, wodurch die Spule ständig gegen die Messseite, im Konkreten gegen die Abdeckung bzw. die dazwischen angeordnete elektrische Isolierung, gedrückt wird. Dazu kann zwischen der Spule und dem Gehäuseboden ein besonderes, elastisches oder federndes Druckmittel vorgesehen sein, vorzugsweise in Form eines Elastomerrings, der in die Anordnung fest eingebaut wird.

Auch ist es denkbar, dass das Anschlusskabel im Inneren des Gehäuses, nämlich konkret im Anschlussbereich, löttechnisch oder crimptechnisch an die elektrischen Anschlüsse der Spule angeschlossen ist. Im Falle einer solchen - einfachen - Ausgestaltung erübrigt sich die Vorkehrung von Anschlusssteckern, Anschlussbuchsen/Kupplungen, wodurch die Baulänge und das Gewicht des Sensors ganz erheblich reduzierbar ist. Alleine der Verzicht auf besondere Anschlussmittel wie Steckverbinder, Steckbuchsen, etc. führt zu einer Halbierung des Gewichts gegenüber einem konventionellen Sensor mit entsprechenden Anschlussmitteln. Durch die hermetische Abdichtung der messseitigen Spulenanordnung kann auch mit integriertem Kabel sehr einfach und kostengünstig ein hermetisch dichter Sensor aufgebaut werden. Dennoch ist es möglich, dass anschlussseitig am oder im Gehäuse eine Anschlussbuchse oder -stecker vorgesehen ist, wobei die Anschlussbuchse oder der Stecker mit dem Gehäuse verschweißt oder verklebt sein kann. Letztendlich kann es sich bei der Buchse oder dem Stecker um einen in das Gehäuse integrierten Bestandteil handeln.

Zusammenfassend lässt sich festhalten, dass mit dem erfindungsgemäßen Sensor eine hermetische Kapselung des Sensorelements möglich ist, so dass sich der Sensor ganz besonders auch für die Luft- und Raumfahrt eignet.

Die stirnseitig vorgesehene Abdeckung führt insbesondere durch Materialschluss, wahlweise durch Verschweißen, zu einer hermetischen Abdichtung, jedenfalls dann, wenn gleichzeitig die Spulendrähte bzw. Kontaktstifte oder Kontaktröhrchen durch Verglasung abgedichtet sind.

Insgesamt ergeben sich Kostenvorteile in der Herstellung, nicht zuletzt auch aufgrund der Tatsache, dass ein diskreter Kern nicht erforderlich ist. Auf herkömmliche Steckverbindungen kann verzichtet werden, wobei dies nicht erforderlich ist. Jedenfalls ergibt sich im Lichte der voranstehenden Ausführungen eine gegenüber dem Stand der Technik wesentlich kompaktere Bauform, insbesondere eine kürzere Bauform. Dies bedingt wiederum eine nicht unerhebliche Gewichtsersparnis, vor allem dann, wenn auf Steckverbinder verzichtet wird.

Ein weiterer wesentlicher Vorteil der erfindungsgemäßen Lehre ergibt sich aus der kompakten Anordnung und dem Glasverguss, wodurch nämlich eine vibrationsfeste Ausführung realisierbar ist, da die schwingfähigen Massen entsprechend der hier beanspruchten Bauart wesentlich kleiner als beim Stand der Technik sind.

Gleichzeitig ergibt sich eine längere Lebensdauer bzw. Standzeit, da weniger Komponenten erforderlich sind, wodurch sich bereits - per se - die Ausfallwahrscheinlichkeit reduziert. Außerdem lässt sich das Spulenelement - vor dem Anbringen der Abdeckung - von der Messseite her montieren, nämlich unter Nutzung einer besseren Zugänglichkeit. Dies ist gegenüber der Montage herkömmlicher Sensoren montagefreundlicher für den Hersteller.

Schließlich lässt sich durch Vorkehrung einer separaten Abdeckung in Form einer sehr dünnen Scheibe ein größerer Detektionsbereich (Messbereich/Schaltabstand) realisieren, nämlich aufgrund der dünnen Ausführung der Abdeckung. Obendrein ist ein höherer Kupferfüllfaktor möglich als bei Ausführungen mit einem diskreten Kern.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Patentansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: in einer schematischen Explosionsdarstellung die wesentlichen Bestandteile eines aus dem Stand der Technik bekannten Sensors,
- Fig. 2: in einer schematischen Explosionsdarstellung ein erstes Ausführungsbeispiel eines erfindungsgemäßen Sensors und
- Fig. 3: in einer schematischen Seitenansicht, teilweise geschnitten, ein zweites Ausführungsbeispiel eines erfindungsgemäßen Sensors.

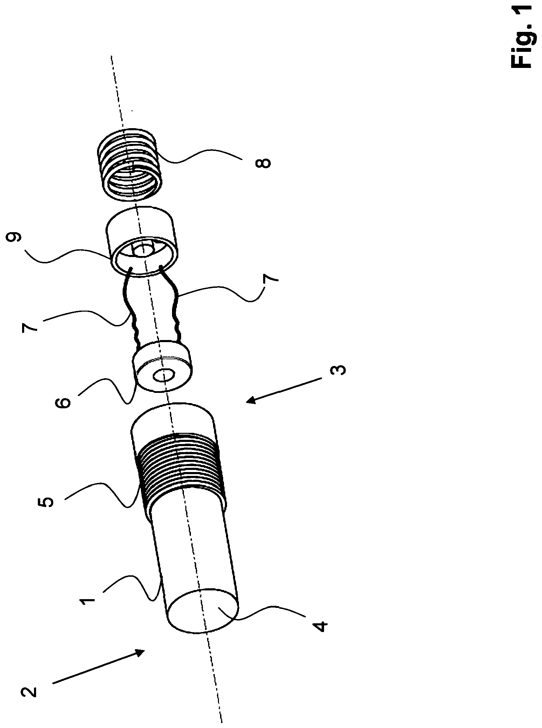

Zum besseren Verständnis der erfindungsgemäßen Lehre zeigt Fig. 1 einen für sich bekannten Sensor, wie er beispielsweise in der US 3,473,110 beschrieben ist. Der Sensor umfasst ein Gehäuse 1, welches eine Messseite 2 und eine Anschlussseite 3 definiert. Das Gehäuse 1 besteht aus Edelstahl und ist inklusive des messseitigen Gehäuseteils 4 aus Edelstahl - einstückig - gefertigt. Die Vorkehrung einer besonderen Abdeckung ist daher auf der Messseite 2 nicht erforderlich.

Fig. 1 zeigt des Weiteren, dass das Gehäuse 1 mit einem Außengewinde 5 versehen ist, wodurch sich das Gehäuse 1 in einer Halterung, einem Aggregat, einer Vorrichtung oder dgl. einschrauben bzw. dort montieren lässt.

In Bezug auf das messseitige Gehäuseteil 4 sei angemerkt, dass dort die Wandstärke möglichst gleichmäßig und dünn ausgeführt sein muss, um eine Dämpfung des Sensors durch Wirbelströme im Wesentlichen zu vermeiden. Die Herstellung einer stirnseitigen dünnen Wandung ist aufwändig und in Bezug auf die Fertigungstechnik kritisch.

Anhand von Fig. 1 lässt sich der Zusammenbau des bekannten Sensors nachvollziehen, wonach die dort vorgesehene Spule 6 in gewickelter Form und mit Anschlussdrähten 7 ausgestattet von der Rückseite, d.h. von der Anschlussseite 3 her, in das Gehäuse 1 eingelegt wird. Die Spule 6 wird mittels einer Feder 8 gegenüber dem messseitigen Gehäuseteil 4, d.h. gegenüber der Messseite 2, vorgespannt. Die Feder 8 dient zur Beaufschlagung der Spule 6 mit definierter Kraft, um diese gegen das messseitige Gehäuseteil 4 zu drücken. Dadurch lässt sich gewährleisten, dass bei Temperaturänderungen die Position der Spule 6 relativ zum messseitigen Gehäuseteil 4 bzw. zur Stirnfläche des Gehäuses 1 erhalten bleibt und nicht durch thermische Änderungen bedingt abweicht.

In Bezug auf den bekannten Sensor ist weiter wesentlich, dass die Spule 6 in einen Topfkern 9 eingelegt wird, wodurch sich ein nicht unbeachtlicher Montageaufwand ergibt.

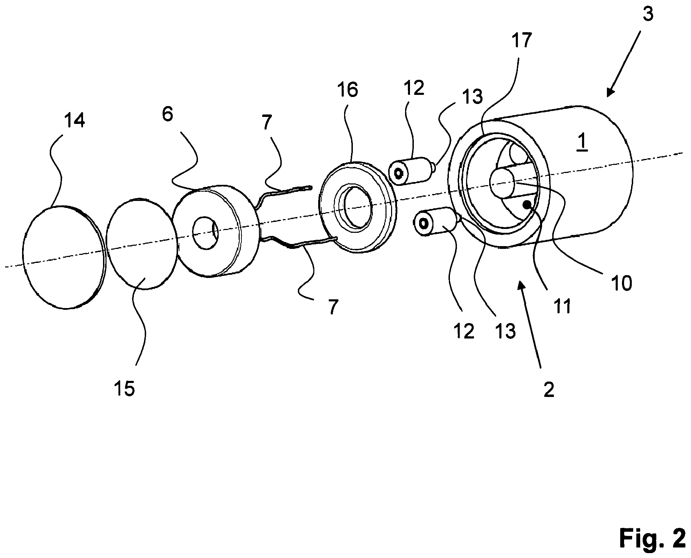

Fig. 2 zeigt ein erstens Ausführungsbeispiel eines erfindungsgemäßen Sensors, wobei dort das Gehäuse 1 aus ferromagnetischem Edelstahl besteht. Außerdem weist das Gehäuse 1 die erforderliche Außenkontur auf, wobei einer einfachen Darstellung wegen auf die Abbildung eines Montagegewindes, eines Montageflanschs oder dgl. verzichtet wurde.

Fig. 2 lässt von der offenen Messseite 2 her deutlich erkennen, dass in das Gehäuse 1 die Kontur eines Topfkerns eingearbeitet ist, in die die Spule 6 eingelegt wird. Genauer gesagt befindet sich im Gehäuse 1 ein als mittiger Zylinder ausgebildeter Zapfen 19, der mit den sonstigen Gehäuseteilen im Sinne eines Topfkerns zusammenwirkt und eine Art Aufnahme 10 bildet.

Die Spule 6 ist mit Anschlussdrähten 7 ausgestattet, wobei zur Durchführung durch einen im Gehäuse 1 befindlichen Bodenbereich 11 Isolier-Durchführungen 12 vorgesehen sind. Endseitig sind die Isolier-Durchführungen 12 mit Kontaktstiften 13 versehen, nämlich zur anschlussseitigen Verbindung mit einer weiterführenden Anschlussleitung.

Je nach Anforderung ist zwischen der Spule 6 und einer zum Schließen des Gehäuses 1 dienenden Abdeckung 14 eine Isolierfolie 15 vorgesehen. Ein Elastomerring 16 dient zur Kraftbeauschlagung der Spule 6, drückt diese nämlich gegen die Abdeckung 14, und zwar von der Innenseite des Gehäuses 1 her.

Die stirnseitige Abdeckung 14 lässt sich messseitige in das Gehäuse 1 einsetzen, nämlich in einen dort vorgesehenen Absatz 17. Dort wird die Abdeckung 14 mit dem Gehäuse 1 verschweißt oder verklebt.

Spulenanschlüsse 7 der Spule 6 werden an den Kontaktstiften angelötet, wobei die Kontaktstifte 13 in den Isolier-Durchführungen 12 sitzen. Die Isolier-Durchführungen 12 können aus Glas oder Keramik hergestellt sein, wobei sich die Herstellung der Durchführungen aus Glas besonders eignet, wonach die Kontaktstifte 13 durch einen Verglasungs-Prozess fest mit dem Gehäuse 1 verbunden werden. Eine solche Verbindung ist hermetisch dicht. Gemeinsam mit der schweißtechnisch mit dem Gehäuse verbundenen stirnseitigen Abdeckung 14 lässt sich die Spule 6 absolut hermetisch dicht kapseln, wodurch der Sensor insgesamt auch widrigsten Umgebungsbedingungen bzw. Atmosphären dauerhaft Stand hält.

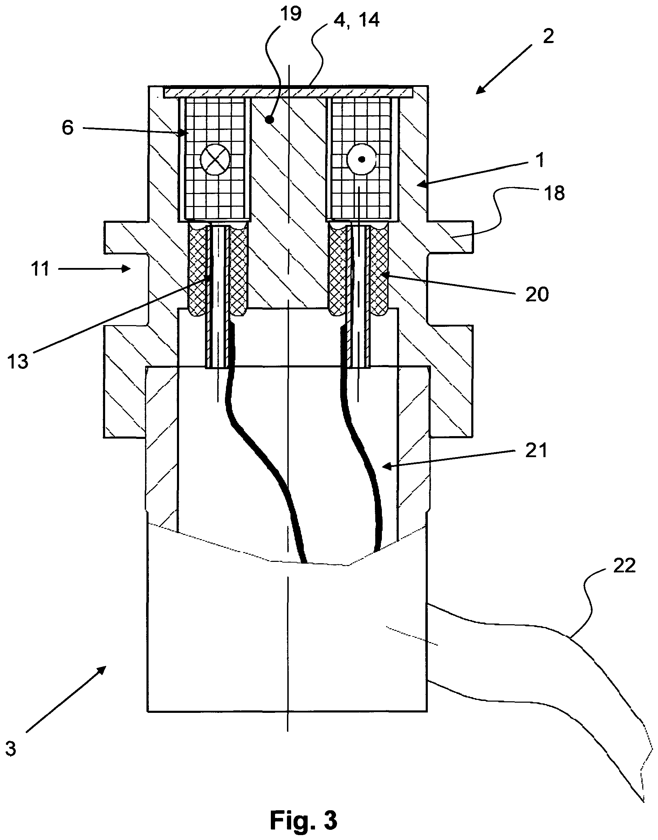

Fig. 3 zeigt ein zweites Ausführungsbeispiel eines erfindungsgemäßen Sensors, gegenüber den Darstellungen in den Fig. 1 und 2 im komplettierten bzw. zusammengebauten Zustand.

Das Gehäuse 1 ist mit einem Befestigungsflansch 18 ausgestattet, wobei an der Außenseite des Gehäuses ohne weiteres auch ein Befestigungsgewinde vorgesehen sein kann.

Die Spule 6 grenzt unmittelbar an die Abdeckung 14, wobei diese aus einem nicht-ferromagnetischen Material besteht, beispielsweise als metallische Scheibe ausgeführt ist.

Das Gehäuse 1 selbst besteht aus einem ferromagnetischen Stahl mit hoher Permeabilität.

Im Inneren ist das Gehäuse 1 im Sinne eines Spulentopfes ausgebildet, wobei ein dort ausgebildeter Zapfen 19 zur Zentrierung der Spule 6 dient.

Im Bodenbereich 11 des Gehäuses 1 sind zwei Kontaktröhrchen 13 elektrische isoliert eingebracht. Zur Isolation und zur hermetischen Abdichtung sind die Kontaktröhrchen 13 mit Glas vergossen, wodurch zwei Glas-Isolationskörper 20 entstanden sind, die einerseits elektrisch isolieren und andererseits hermetisch abdichten. Die Anschlussdrähte 7 der Spule 6 sind innerhalb der Kontaktröhrchen 13 zum Anschlussbereich geführt und dort mit den Kontaktröhrchen 13 verlötet.

Endseitig sind die Kontaktröhrchen 13 mit einer weiterführenden Anschlusslitze 21 verlötet. Das Lötzinn dringt im geschmolzenen Zustand in die Kontaktröhrchen 13 ein, wodurch auch insoweit eine hermetische Abdichtung geschaffen ist.

Bei dem in Fig. 3 gezeigten Ausführungsbeispiel ist die Anschlussleitung 22 über deren Anschlusslitzen 21 unmittelbar mit den Kontaktröhrchen 13 verbunden, so dass die Vorkehrung weiterer Anschlussmittel, beispielsweise eines Steckers, nicht erforderlich ist. Entsprechend baut der erfindungsgemäße Sensor äußerst kurz.

In Bezug auf Merkmale, die sich den voranstehend erörterten Figuren nicht entnehmen lassen, sei zur Vermeidung von Wiederholungen auf den allgemeinen Teil der Beschreibung verwiesen.

Schließlich sei angemerkt, dass die voranstehend beschriebenen Ausführungsbeispiele lediglich der beispielhaften Erörterung der beanspruchten Lehre dienen, diese jedoch nicht auf die Ausführungsbeispiele einschränken.

### Bezugszeichenliste

- 1: Gehäuse
- 2: Messseite (des Gehäuses)
- 3: Anschlussseite (des Gehäuses)
- 4: messseitiger Gehäuseteil
- 5: Außengewinde (des Gehäuses)
- 6: Spule
- 7: Anschlussdrähte
- 8: Feder
- 9: Topfkern
- 10: Aufnahme
- 11: Bodenbereich (im Innern des Gehäuses)
- 12: Isolier-Durchführung
- 13: Kontaktstift, Kontaktröhrchen
- 14: Abdeckung (stirnseitig am/im Gehäuse)
- 15: Isolierfolie
- 16: Elastomerring
- 17: Absatz (stirnseitig im Gehäuse)
- 18: Befestigungsflansch
- 19: Zapfen, Zylinder (im Innern des Gehäuses)
- 20: Glas-Isolationskörper
- 21: Anschlusslitze
- 22: Anschlussleitung

## Patentansprüche

1. Sensor mit einem eine Messseite und eine Anschlussseite definierenden Gehäuse (1), einer in dem Gehäuse (1) messseitig angeordneten Spule (6) und einer Abdeckung (14) zum messseitigen Verschließen des Gehäuses (1), wobei das Gehäuse (1) aus ferromagnetischem Material, insbesondere aus ferromagnetischem Stahl, gefertigt ist und wobei die Spule (6) nahe der Abdeckung (14) oder unmittelbar an der Abdeckung (14) im Gehäuse (1) positioniert und fixiert und in einer Aufnahme (10) angeordnet ist,
**dadurch gekennzeichnet, dass** die Aufnahme (10) im Inneren des Gehäuses (1) als integraler Bestandteil des Gehäuses (1) ausgebildet ist, wobei das Gehäuse einen Bodenbereich (11) aufweist, wobei im Inneren des Gehäuses, in koaxialer Anordnung ein Zapfen (19) zur Positionierung der Spule (6) ausgebildet ist, und dass der Zapfen (19) als mittiger Zylinder (19) integral mit dem Bodenbereich des Gehäuses (1) ausgebildet ist, wobei der Zapfen (19) in Verbindung mit dem Bodenbereich und dem Gehäuse (1) einen integral ausgebildeten Topfkern bildet.

2. Sensor nach Anspruch 1, **dadurch gekennzeichnet, dass** das Gehäuse (1) im Innern durch den Bodenbereich (11) in einen messseitigen Spulenbereich und in einen anschlussseitigen Anschlussbereich unterteilt ist.

3. Sensor nach Anspruch 2, **dadurch gekennzeichnet, dass** die Spule (6) zwei vorzugsweise starre Anschlusskontakte, vorzugsweise in Form angelöteter Kontaktstifte oder Kontaktröhrchen (13), umfasst, die sich durch Durchgänge im Bodenbereich (11) in den Anschlussbereich hinein erstrecken, wobei die Anschlusskontakte gegenüber dem Gehäuse (1) elektrisch isoliert sind.

4. Sensor nach Anspruch 3, **dadurch gekennzeichnet, dass** als Isolation jeweils eine Isolier-Durchführung (12), beispielsweise aus Keramik oder Glas, vorgesehen ist, die in die Durchgänge eingesteckt, eingepresst, eingeklebt oder eingelötet ist, wobei
als Isolation eine die Durchgänge und somit den Spulenbereich gegenüber dem Anschlussbereich abdichtende Verglasung vorgesehen sein kann.

5. Sensor nach Anspruch 3 oder 4, **dadurch gekennzeichnet, dass** die Spule (6) mit den Anschlussdrähten (7) an den Anschlusskontakten (13), vorzugsweise löttechnisch oder crimptechnisch, verbunden ist.

6. Sensor nach einem der Ansprüche 1 bis 5, **dadurch gekennzeichnet, dass** die Abdeckung (14) nicht-ferromagnetisch ausgeführt ist, wobei
die Abdeckung (14) als Metall- oder Keramikscheibe ausgeführt sein kann.

7. Sensor nach Anspruch 6, **dadurch gekennzeichnet, dass** die Abdeckung (14) stoffschlüssig in das messseitige Ende des Gehäuses (1) eingepasst ist.

8. Sensor nach Anspruch 6 oder 7, **dadurch gekennzeichnet, dass** die Abdeckung (14) mit dem Gehäuse (1) verklebt, verschweißt oder verlötet ist.

9. Sensor nach einem der Ansprüche 1 bis 8, **dadurch gekennzeichnet, dass** zwischen der Abdeckung (14) und der Spule (6) ein elektrischer Isolierkörper, vorzugsweise in Form einer Isolierscheibe oder einer Isolierfolie (15), angeordnet ist.

10. Sensor nach einem der Ansprüche 1 bis 9, **dadurch gekennzeichnet, dass** zwischen der Spule (6) und dem Boden ein Druckmittel, vorzugsweise in Form eines Elastomerringes (16), angeordnet ist, wodurch die Spule (6) ständig gegen die Abdeckung (14) gedrückt wird.

11. Sensor nach einem der Ansprüche 1 bis 10, **dadurch gekennzeichnet, dass** anschlussseitig am oder im Gehäuse (1) ein Anschlussstecker oder eine Anschlussbuchse vorgesehen ist, wobei der Anschlussstecker oder die Anschlussbuchse mit dem Gehäuse (1) verschweißt, verschraubt oder verklebt sein kann.

## Claims

1. Sensor having a housing (1) which defines a measurement side and a connection side, a coil (6) which is arranged in the housing (1) at the measurement side and a cover (14) for closing the housing (1) at the measurement side, wherein the housing (1) is produced from ferromagnetic material, in particular from ferromagnetic steel, and wherein the coil (6) is positioned and fixed close to the cover (14) or directly on the cover (14) in the housing (1) and is arranged in a receiving member (10),
**characterised in that** the receiving member (10) is constructed inside the housing (1) as an integral component of the housing (1), wherein the housing has a base region (11), wherein a pin (19) for positioning the coil (6) is formed inside the housing in a coaxial arrangement, and **in that** the pin (19) is constructed as a central cylinder (19) integrally with the base region of the housing (1), wherein the pin (19) together with the base region and the housing (1) forms an integrally constructed cup core.

2. Sensor according to claim 1, **characterised in that** the housing (1) is subdivided at the inner side by the base region (11) into a measurement-side coil region and a connection-side connection region.

3. Sensor according to claim 2, **characterised in that** the coil (6) comprises two preferably rigid connection contacts, preferably in the form of soldered contact pins or contact pipes (13), which extend through passages in the base region (11) into the connection region, wherein the connection contacts are electrically insulated with respect to the housing (1).

4. Sensor according to claim 3, **characterised in that** there is provided as insulation in each case an insulation bushing (12), for example, of ceramic material or glass, which is inserted, pressed, adhesively bonded or soldered in the passages, wherein glazing which seals the passages and consequently the coil region with respect to the connection region may be provided as insulation.

5. Sensor according to claim 3 or 4, **characterised in that** the coil (6) is connected to the connection wires (7) at the connection contacts (13), preferably using soldering or crimping techniques.

6. Sensor according to any one of claims 1 to 5, **characterised in that** the cover (14) is constructed in a nonferromagnetic manner, wherein the cover (14) may be constructed as a metal or ceramic disc.

7. Sensor according to claim 6, **characterised in that** the cover (14) is fitted in a materially integral manner in the measurement-side end of the housing (1).

8. Sensor according to claim 6 or 7, **characterised in that** the cover (14) is adhesively bonded, welded or soldered to the housing (1).

9. Sensor according to any one of claims 1 to 8, **characterised in that** an electrical insulating member, preferably in the form of an insulating plate or an insulating film (15), is arranged between the cover (14) and the coil (6).

10. Sensor according to any one of claims 1 to 9, **characterised in that** a pressure means, preferably in the form of an elastomer ring (16), is arranged between the coil (6) and the base, whereby the coil (6) is constantly pressed against the cover (14).

11. Sensor according to any one of claims 1 to 10, **characterised in that** a connection plug or a connection bush is provided at the connection side on or in the housing (1), wherein the connection plug or the connection bush can be welded, screwed or adhesively bonded to the housing (1).

## Revendications

1. Capteur avec un boîtier (1) définissant un côté mesure et un côté connexion, une bobine (6) disposée côté mesure dans le boîtier (1), et un couvercle (14) destiné à la fermeture côté mesure du boîtier (1), le boîtier (1) étant réalisé en matériau ferromagnétique, en particulier en acier ferromagnétique, et la bobine (6) étant positionnée et fixée près du couvercle (14) ou directement sur le couvercle (14) dans le boîtier (1) et disposée dans un logement (10), **caractérisé en ce que** le logement (10) est constitué à l'intérieur du boîtier (1) en tant que partie intégrante du boîtier (1), le boîtier comportant une zone de fond (11), un tenon (19) destiné au positionnement de la bobine (6) étant constitué à l'intérieur du boîtier dans un agencement coaxial, et **en ce que** le tenon (19) est constitué en tant que cylindre (19) central d'un seul tenant avec la zone de fond du boîtier (1), le tenon (19) formant, en liaison avec la zone de fond et le boîtier (1), un noyau en pot constitué d'un seul tenant.

2. Capteur selon la revendication 1, **caractérisé en ce que** le boîtier (1) est divisé à l'intérieur par la zone de fond (11) en une zone de bobine côté mesure et une zone de connexion côté connexion.

3. Capteur selon la revendication 2, **caractérisé en ce que** la bobine (6) comprend deux contacts de connexion de préférence rigides, de préférence sous la forme de broches de contact ou tubulures de contact (13) brasées qui s'étendent dans l'intérieur de la zone de connexion à travers des passages dans la zone de fond (11), les contacts de connexion étant isolés électriquement vis-à-vis du boîtier (1).

4. Capteur selon la revendication 3, **caractérisé en ce qu'**il est prévu comme isolation respectivement une traversée isolante (12), par exemple en céramique ou en verre, qui est mise en place dans les passages par emboîtement, pression, collage ou brasage,
un vitrage assurant l'étanchéité des passages et donc de la zone de bobine vis-à-vis de la zone de connexion pouvant être prévu comme isolation.

5. Capteur selon la revendication 3 ou 4, **caractérisé en ce que** la bobine (6) est raccordée aux fils de connexion (7) sur les contacts de connexion (13), par exemple par brasage ou par sertissage.

6. Capteur selon l'une des revendications 1 à 5, **caractérisé en ce que** le couvercle (14) est réalisé de façon non ferromagnétique,
le couvercle (14) pouvant être réalisé en tant que disque en métal ou en céramique.

7. Capteur selon la revendication 6, **caractérisé en ce que** le couvercle (14) est inséré par liaison de matière dans l'extrémité côté mesure du boîtier (1).

8. Capteur selon la revendication 6 ou 7, **caractérisé en ce que** le couvercle (14) est assemblé au boîtier (1) par collage, soudage ou brasage.

9. Capteur selon l'une des revendications 1 à 8, **caractérisé en ce que**, entre le couvercle (14) et la bobine (6), il est disposé un corps électriquement isolant, de préférence sous la forme d'un disque isolant ou d'une feuille isolante (15).

10. Capteur selon l'une des revendications 1 à 9, **caractérisé en ce que**, entre la bobine (6) et le fond, il est disposé un moyen de pression, de préférence sous la forme d'une bague en élastomère (16), ce qui fait que la bobine (6) est pressée constamment contre le couvercle (14).

11. Capteur selon l'une des revendications 1 à 10, **caractérisé en ce que**, côté connexion, sur ou dans le boîtier (1), il est prévu une fiche de connexion ou une douille de connexion, la fiche de connexion ou la douille de connexion pouvant être assemblée au boîtier (1) par soudage, vissage ou collage.
